# EUROPÄISCHE PATENTANMELDUNG

(11) **EP 1 684 216 A1**
(43) Veröffentlichungstag der Anmeldung: **26.07.2006**
(21) Anmeldenummer: 06000812.5
(22) Anmeldetag: 16.01.2006
(51) Int. Cl.: G06K 19/077

(54) **Tragbarer Datenträger**

(30) Priorität: 20.01.2005 DE 102005002732
(71) Anmelder: Giesecke & Devrient GmbH, 81677 München (DE)
(72) Erfinder: Yahya, Haghiri, 80797 München (DE); Wiech, Oliver, 79541 Lörrach (DE); Ojster, Albert, 81373 München (DE); Tarantino, Thomas, 83410 Laufen (DE); Welling, Ando, Dr., 84424 Isen (DE); Hohmann, Arno, 81369 München (DE); Barak Renee-Lucia, 82008 Unterhaching (DE); Graßl, Thomas, Dr., 23560 Lübeck (DE)

(57) **Zusammenfassung**

Die Erfindung betrifft einen tragbaren Datenträger (1) mit einem Datenträgerkörper (2), der wenigstens eine elektrische Komponente (6) aufweist und mit einem elektronischen Modul (3), das teilweise in den Datenträgerkörper (2) eingebettet ist. Das elektronische Modul (3) weist auf einer Vorderseite, die nicht in den Datenträgerkörper (2) eingebettet ist, wenigstens eine elektrisch leitfähige Struktur auf und ist über wenigstens eine elektrisch leitende Verbindung mit der elektrischen Komponente (6) des Datenträgerkörpers (2) verbunden. Der erfindungsgemäße tragbare Datenträger (1) zeichnet sich dadurch aus, dass die elektrisch leitende Verbindung über die elektrisch leitfähige Struktur auf der Vorderseite des elektronischen Moduls (3) ausgebildet ist.

## Beschreibung

Die Erfindung betrifft einen tragbaren Datenträger. Weiterhin betrifft die Erfindung ein elektronisches Modul für einen tragbaren Datenträger und ein Verfahren zur Herstellung eines tragbaren Datenträgers.

Kartenförmige Datenträger, insbesondere Chipkarten werden in vielen Bereichen eingesetzt, beispielsweise als Ausweisdokumente, zum Nachweis einer Zugangsberechtigung zu einem Mobilfunknetz oder zur Durchführung von Transaktionen des bargeldlosen Zahlungsverkehrs. Eine Chipkarte weist einen Kartenkörper und einen in den Kartenkörper eingebetteten integrierten Schaltkreis auf. Um eine effiziente Herstellung der Chipkarte zu ermöglichen, wird der integrierte Schaltkreis bei einer Vielzahl von Herstellungsverfahren zunächst in ein Chipmodul verpackt und anschließend das Chipmodul in den Kartenkörper eingebaut. Insbesondere wird das Chipmodul in eine Aussparung des Kartenkörpers eingeklebt.

Eine Kommunikation mit dem integrierten Schaltkreis kann über ein Kontaktfeld der Chipkarte abgewickelt werden, das hierzu von einer Kontaktiereinheit berührend kontaktiert wird. Das Kontaktfeld ist in der Regel Bestandteil des Chipmoduls. Alternativ oder zusätzlich zur Kommunikation über das Kontaktfeld kann eine kontaktlose Kommunikation vorgesehen sein. Hierzu kann der Kartenkörper eine Antenne aufweisen, die beim Einbau des Chipmoduls mit dem integrierten Schaltkreis elektrisch leitend verbunden wird. Abhängig vom Einsatzgebiet, für welches die Chipkarte vorgesehen ist, kann der Kartenkörper außer der Antenne auch andere oder weitere elektrische Komponenten aufweisen, die beim Einbau des Chipmoduls mit dem integrierten Schaltkreis elektrisch leitend verbunden werden.

Bei der überwiegenden Zahl der für den Einbau eines Chipmoduls in einen Kartenkörper verwendeten Techniken sind die Bereiche, in denen die elektrisch leitenden Verbindungen zwischen dem integrierten Schaltkreis des Chipmoduls und der elektrischen Komponente des Kartenkörpers ausgebildet werden, nicht direkt mittels eines Werkzeugs zugänglich. Es sind daher Kontaktierungsverfahren erforderlich, die trotz dieser fehlenden Zugangsmöglichkeit eine Ausbildung einer elektrisch leitenden Verbindung zwischen dem integrierten Schaltkreis und der elektrischen Komponente ermöglichen.

Diesbezüglich offenbart die WO 97/05569 A1 einen Datenträger, bei dem beispielsweise mittels eines elektrisch leitenden Klebstoffs eine elektrische Verbindung zwischen je einem Modulanschlusskontakt und einem Spulenanschlusskontakt ausgebildet wird. Der Klebstoff ist jeweils in einem Kanal enthalten, der sich zwischen je einem Modulanschlusskontakt und einem Spulenanschlusskontakt erstreckt.

Weiterhin ist aus der DE 197 49 650 C2 ein Verfahren zur Herstellung einer elektrischen Verbindung eines Moduls mit einer Antennenschicht oder einer Antennenspule bekannt. Das Modul weist eine elektronische Komponente auf und wird in eine Kavität eines Kartenkörpers einer Chipkarte eingesetzt. In den Kartenkörper wird im Bereich der Kontaktflächen für die Antennenschicht oder Antennenspule mindestens eine Ausnehmung je Kontakt eingebracht. Die Ausnehmung fixiert ein elastisches Kontaktelement, insbesondere eine Schraubenfeder, so dass die Enden des Kontaktelements die Kontaktflächen für die Antennenschicht oder Antennenspule einerseits und die Gegenkontaktflächen des Moduls andererseits berühren. Anstelle des elastischen Kontaktelements kann ein leitfähiger metallischer Bolzen in die Ausnehmung eingebracht werden. Der Bolzen kann durch Leitkleber oder durch Löten mit den Kontaktflächen für die Antennenschicht oder Antennenspule und den Gegenkontaktflächen des Moduls verbunden werden.

Aus der DE 197 08 617 C2 ist ein Chipkartenmodul mit einem Halbleiterchip bekannt, der elektrisch leitend mit einem metallischen Anschlussrahmen kontaktiert ist. Insbesondere kann diese Kontaktierung dadurch ausgebildet sein, dass Anschlussflächen des Halbleiterchips an Kontaktflächen des Anschlussrahmens gelötet sind.

Der Erfindung liegt die Aufgabe zugrunde, in einem tragbaren Datenträger eine elektrisch leitende Verbindung zwischen einem elektronischen Modul und einer elektrischen Komponente eines Datenträgerkörpers in möglichst optimaler Weise auszubilden.

Diese Aufgabe wird durch einen tragbaren Datenträger mit der Merkmalskombination des Anspruchs 1 gelöst.

Der erfindungsgemäße tragbare Datenträger weist einen Datenträgerkörper mit wenigstens einer elektrischen Komponente und ein elektronisches Modul auf, das teilweise in den Datenträgerkörper eingebettet ist. Das elektronische Modul weist auf einer Vorderseite, die nicht in den Datenträgerkörper eingebettet ist, wenigstens eine elektrisch leitfähige Struktur auf und ist über wenigstens eine elektrisch leitende Verbindung mit der elektrischen Komponente des Datenträgerkörpers verbunden. Die Besonderheit des erfindungsgemäßen tragbaren Datenträgers besteht darin, dass die elektrisch leitende Verbindung über die elektrisch leitfähige Struktur auf der Vorderseite des elektronischen Moduls ausgebildet ist.

Die Erfindung hat den Vorteil, dass mit geringem Aufwand eine zuverlässige elektrisch leitende Verbindung zwischen dem elektronischen Modul und der elektrischen Komponente des Datenträgerkörpers ausgebildet ist, die dauerhaft einer hohen mechanischen Beanspruchung des tragbaren Datenträgers standhält. Weiterhin ist es von Vorteil, dass beim elektronischen Modul lediglich eine einseitige Metallisierung erforderlich ist, die beispielsweise ohnehin zur Ausbildung eines Kontaktfeldes für eine berührende Kontaktierung durch ein externes Gerät benötigt wird.

Das erfindungsgemäße elektronische Modul weist auf einer Rückseite ein elektronisches Bauteil und auf einer dazu entgegengesetzten Vorderseite wenigstens eine elektrisch leitfähige Struktur auf. Die elektrisch leitfähige Struktur ist mit einem Kontakt des elektronischen Bauteils verbunden, der für einen Anschluss einer elektrischen Komponente des Datenträgerkörpers vorgesehen ist.

Der tragbare Datenträger kann ein kartenförmiger Datenträger, insbesondere in Form einer Chipkarte im Sinne der ISO 7816 bzw. einer SIM-Karte, ein Datenträger mit USB-Anschluss (USB-Token) oder ein ähnlich aufgebauter, auf eine Person bezogener Datenträger sein.

Beim erfindungsgemäßen Verfahren zur Herstellung eines tragbaren Datenträgers wird ein elektronisches Modul so in eine Aussparung des Datenträgerkörpers eingesetzt, dass eine elektrisch leitfähige Struktur des elektronischen Moduls nach außen weist und eine elektrisch leitende Verbindung zwischen dem elektronischen Modul und einer elektrischen Komponente des Datenträgerkörpers ausgebildet wird. Dabei wird die elektrisch leitende Verbindung über die elektrisch leitfähige Struktur des elektronischen Moduls ausgebildet.

Die Erfindung wird nachstehend anhand der in der Zeichnung dargestellten Ausführungsbeispiele erläutert, die sich auf einen tragbaren Datenträger in Form einer Chipkarte beziehen.

### Es zeigen:

- Fig. 1: ein Ausführungsbeispiel einer erfindungsgemäß ausgebildeten Chipkarte in einer schematisierten Aufsicht,
- Fig. 2: ein Ausführungsbeispiel des Datenträgerkörpers der erfindungsgemäßen Chipkarte vor dem Einsetzen des Chipmoduls ausschnittsweise in einer schematisierten Aufsicht,
- Fig. 3: ein Ausführungsbeispiel des erfindungsgemäßen Chipmoduls vor dem Einbau in den Datenträgerkörper der Chipkarte in einer schematisierten Aufsicht und
- Fig. 4: das in Fig. 1 dargestellte Ausführungsbeispiel der erfindungsgemäßen Chipkarte in einer schematisierten ausschnittsweisen Schnittdarstellung.

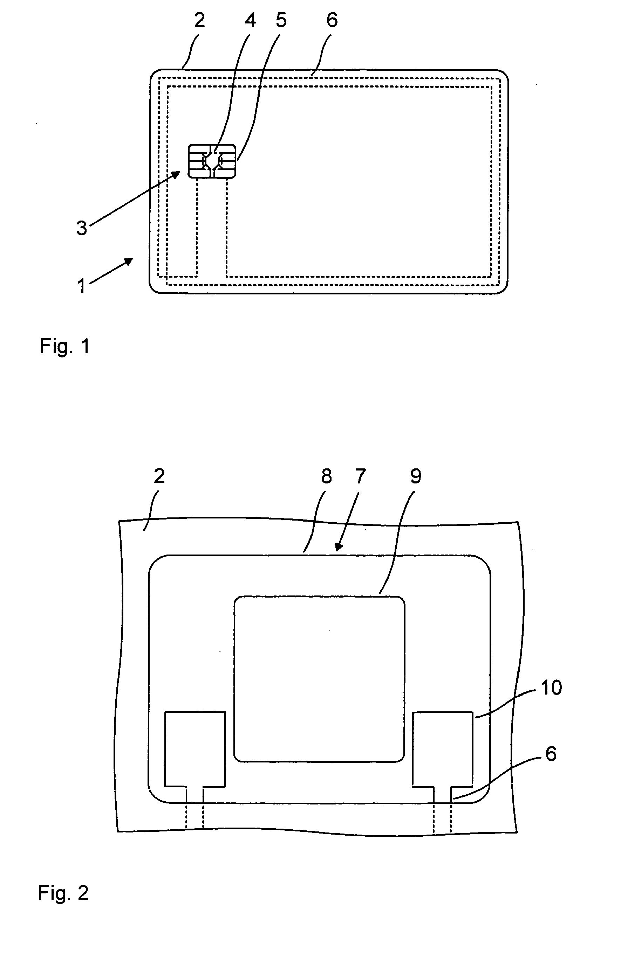

Fig. 1 zeigt ein Ausführungsbeispiel einer erfindungsgemäß ausgebildeten Chipkarte 1 in einer schematisierten Aufsicht. Die Chipkarte 1 weist einen Datenträgerkörper 2 auf, in den ein Chipmodul 3 eingesetzt ist. Das Chipmodul 3 verfügt über einen integrierten Schaltkreis 4 zum Speichern und/ oder Verarbeiten von Daten. Weiterhin verfügt das Chipmodul 3 über ein Kontaktfeld 5, das an der Außenseite des Datenträgerkörpers 2 angeordnet ist und den im Inneren des Datenträgerkörpers 2 angeordneten integrierten Schaltkreis 4 überdeckt. Zwischen dem integrierten Schaltkreis 4 und dem Kontaktfeld 5 sind mehrere elektrisch leitende Verbindungen ausgebildet, so dass dem integrierten Schaltkreis 4 über das Kontaktfeld 5 diverse elektrische Signale zugeführt werden können und der integrierte Schaltkreis 4 über das Kontaktfeld 5 Signale ausgeben kann. Hierzu kann das Kontaktfeld 5 von einem nicht figürlich dargestellten Schreib-/Lesegerät berührend kontaktiert werden. Die elektrische Belegung des Kontaktfeldes 5 ist durch die Norm ISO/IEC 7816-2 festgelegt.

Der Datenträgerkörper 2 weist in seinem Inneren weiterhin eine Antennenspule 6 auf, die beispielsweise als eine gedruckte Spule oder geätzt oder als eine Drahtspule ausgebildet ist und, ebenso wie der integrierte Schaltkreis 4, von außen nicht sichtbar und deshalb durch gestrichelte Linien dargestellt ist. Die Antennenspule 6 ist elektrisch leitend mit dem integrierten Schaltkreis 4 verbunden und ermöglicht analog zum Kontaktfeld 5 eine Übertragung von Signalen, die vom integrierten Schaltkreis 4 gesendet oder empfangen werden. Im Gegensatz zum Kontaktfeld 5 wird die Signalübertragung über die Antennenspule 6 allerdings kontaktlos ausgeführt, so dass die Chipkarte 1 für diese Signalübertragung in einem Abstand zu einem dafür vorgesehenen Schreib-/Lesegerät angeordnet wird. Die in Fig. 1 dargestellte Chipkarte 1 ist somit in der Lage, sowohl über eine berührende Kontaktierung als auch kontaktlos Signale zu übertragen.

Alternativ oder zusätzlich zur Antennenspule 6 kann der Datenträgerkörper 2 der Chipkarte 1 weitere nicht figürlich dargestellte elektrische Komponenten aufweisen, wie zum Beispiel eine Anzeige, einen Schalter, einen Sensor, eine Batterie usw. Diese elektrischen Komponenten können jeweils mit dem integrierten Schaltkreis 4 elektrisch leitend verbunden sein.

Fig. 2 zeigt ein Ausführungsbeispiel des Datenträgerkörpers 2 der erfindungsgemäßen Chipkarte 1 vor dem Einsetzen des Chipmoduls 3 ausschnittsweise in einer schematisierten Aufsicht. Der Datenträgerkörper 2 ist im Bereich einer Aussparung 7 dargestellt, in die das Chipmodul 3 eingesetzt wird. Die Aussparung 7 ist zweistufig ausgebildet und weist einen Randbereich 8 und einen Zentralbereich 9 auf. Der Zentralbereich 9 ist innerhalb des Randbereichs 8 ausgebildet und reicht tiefer in den Datenträgerkörper 2 hinein als der Randbereich 8. Im Randbereich 8 ist an zwei gegenüberliegenden Seiten des Zentralbereichs 9 je eine Anschlussfläche 10 aus einem elektrisch leitenden Material ausgebildet. Im dargestellten Ausführungsbeispiel sind die beiden Anschlussflächen 10 so ausgebildet, dass sie beim Einsetzen des Chipmoduls 3 in die Aussparung 7 mit den gemäß ISO/IEC 7816-2 mit C4 und C8 bezeichneten Kontaktflächen des Kontaktfeldes 5 lateral überlappen. An die beiden Anschlussflächen 10 ist je ein Ende der Antennenspule 6 angeschlossen, so dass über die Anschlussflächen 10 eine elektrisch leitende Verbindung zur Antennenspule 6 ausgebildet werden kann. Die Anschlussflächen 10 können insbesondere einteilig mit der Antennenspule 6 ausgebildet sein.

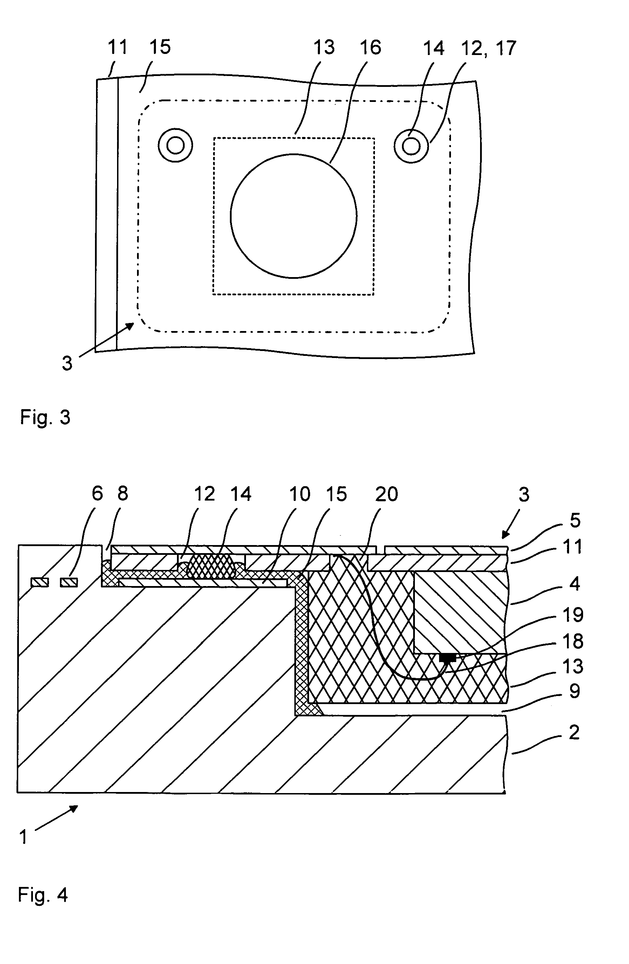

Fig. 3 zeigt ein Ausführungsbeispiel des erfindungsgemäßen Chipmoduls 3 vor dem Einbau in den Datenträgerkörper 2 der Chipkarte 1 in einer schematisierten Aufsicht. Dargestellt ist die Seite des Chipmoduls 3, die im eingebauten Zustand dem Inneren des Datenträgerkörpers 2 der Chipkarte 1 zugewandt ist. Diese Seite wird im Folgenden als Rückseite des Chipmoduls 3 bezeichnet. In entsprechender Weise wird die Seite des Chipmoduls 3, auf der das Kontaktfeld 5 angeordnet ist, im Folgenden als Vorderseite bezeichnet.

Das Chipmodul 3 ist bezüglich seiner lateralen Abmessungen, die durch eine strichpunktierte Linie verdeutlicht sind, kleiner als die Außenabmessungen des Randbereichs 8 der Aussparung 7 des Datenträgerkörpers 2 und weist eine Trägerfolie 11 auf, auf der zur Vorderseite des Chipmoduls 3 hin das Kontaktfeld 5 angeordnet ist. Die Trägerfolie 11 besteht aus einem elektrisch isolierenden Material, beispielsweise aus Epoxid. Beim dargestellten Ausführungsbeispiel ist die Trägerfolie 11 als ein Band ausgebildet und stellt einen gemeinsamen Bestandteil einer Vielzahl von Chipmodulen 3 dar. Die Chipmodule 3 sind beispielsweise in zwei Reihen angeordnet und werden erst unmittelbar vor dem Einbau in den Datenträgerkörper 2 aus der Trägerfolie 11 ausgestanzt.

Bei jedem Chipmodul 3 weist die Trägerfolie 11 zwei Durchbrechungen 12 auf, über die das Kontaktfeld 5 von der Rückseite des Chipmoduls 3 aus zugänglich ist. Die Durchbrechungen 12 sind so ausgebildet, dass darüber zwei Bereiche des Kontaktfeldes 5 zugänglich sind, die in der Regel nicht anderweitig benötigt werden und daher für den Anschluss der Antennenspule 6 an den integrierten Schaltkreis 4 des Chipmoduls 3 verwendet werden können. Hierfür kommen beispielsweise zwei der gemäß ISO/IEC-7816-2 als C4, C6 und C8 bezeichneten Kontaktflächen in Frage. Beim dargestellten Ausführungsbeispiel werden die Kontaktflächen C4 und C8 verwendet. Ebenso kann auch ein Bereich im Zentrum des Kontaktfeldes 5 verwendet werden, der üblicherweise mit einer als C5 bezeichneten Kontaktfläche verbunden ist, die als Masseanschluss dient. Der Bereich ist für diese Variante der Erfindung so umgestaltet, dass er zwei elektrisch isolierte Teilbereiche aufweist.

Damit das Kontaktfeld 5 über die Durchbrechungen 12 zugänglich ist, sind diese seitlich neben einem Vergusskörper 13 angeordnet, in den der integrierte Schaltkreis 4 eingebettet ist. Auch wenn von der in Fig. 3 dargestellten Geometrie abgewichen wird, werden die Anordnung der Durchbrechungen 12 und die Ausbildung des Vergusskörpers 13 so aufeinander abgestimmt, dass die Durchbrechungen 12 durch den Vergusskörper 13 nicht abgedeckt werden. Ebenso wird die Anordnung der Durchbrechungen 12 bei der Ausbildung der Anschlussflächen 10 des Datenträgerkörpers 2 derart berücksichtigt, dass es beim Einsetzen des Chipmoduls 3 in die Aussparung 7 des Datenträgerkörpers 2 zu einer lateralen Überlappung zwischen den Anschlussflächen 10 und den Durchbrechungen 12 kommt. Um eine problemlose Montage des Chipmoduls 3 zu ermöglichen ist außerdem die Aussparung 7 des Datenträgerkörpers 2 so auf die Außenabmessungen des Vergusskörpers 13 abgestimmt, dass der Vergusskörper 13 vom Zentralbereich 9 der Aussparung 7 aufgenommen werden kann.

Für die Ausbildung einer elektrisch leitenden Verbindung zwischen den dafür vorgesehenen Bereichen des Kontaktfeldes 5 des Chipmoduls 3 und den Anschlussflächen 10 des Datenträgerkörpers 2 ist auf der Rückseite des Chipmoduls 3 innerhalb der Durchbrechungen 12 jeweils ein Lot 14, beispielsweise in Form einer kleinen Kugel, auf das Kontaktfeld 5 aufgebracht. Bei dem Lot 14 handelt es sich bevorzugt um ein niedrig schmelzendes Weichlot. Weiterhin ist auf die Rückseite jedes Chipmoduls 3 ein thermisch aktivierbarer Kleber 15 in Form einer dünnen Folie aufgebracht, welche im Bereich des Vergusskörpers 13 eine zentrale Ausstanzung 16 und im Bereich der Durchbrechungen 12 je eine periphere Ausstanzung 17 aufweist. Im dargestellten Ausführungsbeispiel sind die peripheren Ausstanzungen 17 dekkungsgleich mit den Durchbrechungen 12 der Trägerfolie 11 ausgebildet. Mit Hilfe des thermisch aktivierbaren Klebers 15 wird das Chipmodul 3 dauerhaft mit dem Datenträgerkörper 2 verbunden.

Fig. 4 zeigt das in Fig. 1 dargestellte Ausführungsbeispiel der erfindungsgemäßen Chipkarte 1 in einer schematisierten ausschnittsweisen Schnittdarstellung. Der dargestellte Ausschnitt zeigt den Datenträgerkörper 2 im Bereich eines der beiden Anschlussflächen 10. Das Chipmodul 3 ist im Bereich einer der beiden Durchbrechungen 12 dargestellt. Dabei ist insbesondere auch einer von mehreren Bonddrähten 18 skizziert, die innerhalb des Vergusskörpers 13 verlaufen und das Kontaktfeld 5 elektrisch leitend mit Kontakten 19 des integrierten Schaltkreises 4 verbinden. Der dargestellte Bonddraht 18 verbindet die Kontaktfläche C4 des Kontaktfeldes 5 mit dem für den Anschluss der Antennenspule 6 vorgesehenen Kontakt 19 des integrierten Schaltkreises 4. Um das Kontaktfeld 5 für die auf der Rückseite des Chipmoduls 3 angeordneten Bonddrähte 18 zugänglich zu machen, weist die Trägerfolie 11 mehrere Durchbrechungen 20 auf. Im Gegensatz zu den Durchbrechungen 12 sind die Durchbrechungen 20 allerdings innerhalb des Vergusskörpers 13 angeordnet, da der Vergusskörper 13 nicht nur den integrierten Schaltkreis 4, sondern auch die Bonddrähte 18 schützen soll. Folglich sind die Durchbrechungen 20 nach Ausbildung des Vergusskörpers 13 nicht mehr zugänglich.

### Bei der Herstellung der Chipkarte 1 wird folgendermaßen vorgegangen:

Das Chipmodul 3 wird aus der Trägerfolie 11 ausgestanzt und in die Aussparung 7 des Datenträgerkörpers 2 eingesetzt. Durch Zufuhr von Wärmeenergie wird der Kleber 15 aktiviert, so dass er das Chipmodul 3 fest und dauerhaft mit dem Datenträgerkörper 2 verklebt. Weiterhin wird das Lot 14 durch eine lokale Wärmeenergiezufuhr so stark erwärmt, dass es erweicht und sowohl das Kontaktfeld 5 des Chipmoduls 3 als auch die jeweils benachbarte Anschlussfläche 10 des Datenträgerkörpers 2 benetzt. Je nach Größe der peripheren Ausstanzungen 17 dringt der erweichte Kleber 15 bis zum erweichten Lot 14 vor und umschließt dieses. Die Wärmeenergie kann beispielsweise jeweils mittels eines Heißstempels, mittels eines induzierten Wirbelstroms, mittels Ultraschall oder mittels eines Lasers lokal zugeführt werden.

Beim Erkalten erhärten der Kleber 15 und das Lot 14. Dabei wird durch den Kleber 15 eine stoffschlüssige Verbindung zwischen dem Chipmodul 3 und dem Datenträgerkörper 2 ausgebildet. Durch das Lot 14 werden stoffschlüssige und elektrisch leitende Verbindungen zwischen dem Kontaktfeld 5 des Chipmoduls 3 und den Anschlussflächen 10 des Datenträgerkörpers 2 ausgebildet und dadurch die Antennenspule 6 des Datenträgerkörpers 2 an den integrierten Schaltkreis 4 des Chipmoduls 3 angeschlossen. Dieser Anschluss bleibt auch bei starker mechanischer Beanspruchung der Chipkarte 1 auf Dauer zuverlässig erhalten.

Bei einer Abwandlung der Erfindung wird das Lot 14 nicht auf das Kontaktfeld 5 des Chipmoduls 3, sondern auf die Anschlussflächen 10 des Datenträgerkörpers 2 aufgebracht. Ebenso ist es auch möglich, das Lot 14 sowohl auf das Kontaktfeld 5 als auch auf die Anschlussflächen 10 aufzubringen. In diesem Fall kann jeweils eine entsprechend kleinere Menge aufgebracht werden.

Bei einer weiteren Abwandlung der Erfindung wird zur Ausbildung der elektrisch leitenden Verbindungen anstelle des Lots 14 ein Leitkleber eingesetzt. Weiterhin ist es auch möglich, die elektrisch leitende Verbindung ohne einen Stoffschluss durch eine mechanische Berührung des Kontaktfeldes 5 des Chipmoduls 3 und der Anschlussflächen 10 des Datenträgerkörpers 2 auszubilden. Hierzu werden die Anschlussflächen 10 so geformt, dass sie das Kontaktfeld 5 durch die Durchbrechungen 12 hindurch kontaktieren können oder es werden elektrisch leitfähige Zusatzelemente jeweils im Bereich zwischen dem Kontaktfeld 5 und der zugehörigen Anschlussfläche 10 angeordnet. Bei allen Varianten werden letztendlich elektrisch leitende Verbindungen zwischen den Anschlussflächen 10 und dem Kontaktfeld 5 hergestellt, das wiederum mit dem integrierten Schaltkreis 4 elektrisch leitend verbunden ist. Hierfür ist lediglich eine einseitige elektrisch leitfähige Beschichtung der Trägerfolie 11 des Chipmoduls 3 in Form des auf seiner Vorderseite angeordneten Kontaktfeldes 5 erforderlich. Eine zusätzliche elektrisch leitfähige Beschichtung auf der Rückseite des Chipmoduls 3 wird nicht benötigt.

Die Erfindung kann auch so abgewandelt werden, dass für die Verklebung des Chipmoduls 3 mit dem Datenträgerkörper 2 anstelle einer thermoaktivierbaren Klebefolie ein sonstiger Kleber 15, beispielsweise ein Flüssigkleber, eingesetzt wird.

Bei einer weiteren Abwandlung der Erfindung ist das Chipmodul 3 auf andere Weise ausgebildet, als beim vorstehend beschriebenen Ausführungsbeispiel. Auch in diesem Fall werden für die Ausbildung des Chipmoduls 3 jeweils bevorzugt gebräuchliche Standardverfahren der Chipmodulherstellung eingesetzt.

## Patentansprüche

1. Tragbarer Datenträger mit einem Datenträgerkörper (2), der wenigstens eine elektrische Komponente (6) aufweist und mit einem elektronischen Modul (3), wobei das elektronische Modul (3) teilweise in den Datenträgerkörper (2) eingebettet ist, auf einer Vorderseite, die nicht in den Datenträgerkörper (2) eingebettet ist, wenigstens eine elektrisch leitfähige Struktur aufweist und über wenigstens eine elektrisch leitende Verbindung mit der elektrischen Komponente (6) des Datenträgerkörpers (2) verbunden ist, **dadurch gekennzeichnet, dass** die elektrisch leitende Verbindung über die elektrisch leitfähige Struktur auf der Vorderseite des elektronischen Moduls (3) ausgebildet ist.

2. Tragbarer Datenträger nach Anspruch 1, **dadurch gekennzeichnet, dass** die elektrisch leitfähige Struktur auf einem elektrisch isolierenden Träger (11) des elektronischen Moduls (3) angeordnet ist.

3. Tragbarer Datenträger nach Anspruch 2, **dadurch gekennzeichnet, dass** der Träger (11) wenigstens eine Durchbrechung (12) aufweist, die wenigstens partiell mit der elektrisch leitfähigen Struktur überlappt.

4. Tragbarer Datenträger nach einem der vorhergehenden Ansprüche, **dadurch gekennzeichnet, dass** die elektrisch leitfähige Struktur elektrisch leitend mit einer elektrischen Kontakteinrichtung (10) des Datenträgerkörpers (2) verbunden ist, an welche die elektrische Komponente (6) des Datenträgerkörpers (2) angeschlossen ist.

5. Tragbarer Datenträger nach Anspruch 4, **dadurch gekennzeichnet, dass** die elektrisch leitfähige Struktur mittels eines elektrisch leitfähigen Materials (14) stoffschlüssig mit der elektrischen Kontakteinrichtung (10) des Datenträgerkörpers (2) verbunden ist.

6. Tragbarer Datenträger nach Anspruch 5, **dadurch gekennzeichnet, dass** das elektrisch leitfähige Material (14) in der Durchbrechung (12) angeordnet ist.

7. Tragbarer Datenträger nach einem der Ansprüche 4 bis 6, **dadurch gekennzeichnet, dass** das elektronische Modul (3) in einer zweistufigen Aussparung (7) des Datenträgerkörpers (2) angeordnet ist, die einen ersten Bereich (8) und einen zweiten Bereich (9) aufweist, wobei sich der zweite Bereich (9) tiefer als der erste Bereich (8) in den Datenträgerkörper (2) hinein erstreckt und die elektrische Kontakteinrichtung (10) des Datenträgerkörpers (2) im ersten Bereich (8) angeordnet ist.

8. Tragbarer Datenträger nach einem der vorhergehenden Ansprüche, **dadurch gekennzeichnet, dass** die elektrisch leitfähige Struktur Bestandteil eines Kontaktfeldes (5) zur berührenden Kontaktierung des elektronischen Moduls (3) durch ein externes Gerät ist.

9. Tragbarer Datenträger nach Anspruch 8, **dadurch gekennzeichnet, dass** das Kontaktfeld (5) gemäß der Norm ISO/IEC-7816 ausgebildet ist.

10. Tragbarer Datenträger nach Anspruch 9, **dadurch gekennzeichnet, dass** die elektrisch leitfähige Struktur als eine der Kontaktflächen C4, C5 oder C8 des Kontaktfelds (5) ausgebildet ist oder in der Nähe des Zentrums des Kontaktfelds (5) angeordnet ist.

11. Tragbarer Datenträger nach einem der vorhergehenden Ansprüche, **dadurch gekennzeichnet, dass** das elektronische Modul (3) mittels eines Klebers (15) am Datenträgerkörper (2) fixiert ist.

12. Tragbarer Datenträger nach einem der vorhergehenden Ansprüche, **dadurch gekennzeichnet, dass** die elektrische Komponente (6) des Datenträgerkörpers (2) als eine Antenneneinrichtung ausgebildet ist.

13. Tragbarer Datenträger nach einem der vorhergehenden Ansprüche, **dadurch gekennzeichnet, dass** er als eine Chipkarte ausgebildet ist.

14. Elektronisches Modul zum Einbau in einen Datenträgerkörper (2) eines tragbaren Datenträgers (1), der wenigstens eine elektrische Komponente (6) aufweist, wobei auf einer Rückseite des elektronischen Moduls (3) ein elektronisches Bauteil (4) angeordnet ist und auf einer dazu entgegengesetzten Vorderseite des elektronischen Moduls (3) wenigstens eine elektrisch leitfähige Struktur ausgebildet ist, **dadurch gekennzeichnet, dass** die elektrisch leitfähige Struktur mit einem Kontakt (19) des elektronischen Bauteils (4) verbunden ist, der für einen Anschluss der elektrischen Komponente (6) des Datenträgerkörpers (2) vorgesehen ist.

15. Elektronisches Modul nach Anspruch 14, **dadurch gekennzeichnet, dass** die elektrisch leitfähige Struktur auf einem elektrisch isolierenden Träger (11) ausgebildet ist, der wenigstens eine Durchbrechung (12) aufweist, die mit der elektrisch leitfähigen Struktur wenigstens teilweise überlappt und von der Rückseite des elektronischen Moduls (3) zugänglich ist.

16. Verfahren zur Herstellung eines tragbaren Datenträgers (1) aus einem Datenträgerkörper (2) und einem elektronischen Modul (3), wobei das elektronische Modul (3) so in eine Aussparung (7) des Datenträgerkörpers (2) eingesetzt wird, dass eine elektrisch leitfähige Struktur des elektronischen Moduls (3) nach außen weist und eine elektrisch leitende Verbindung zwischen dem elektronischen Modul (3) und einer elektrischen Komponente (6) des Datenträgerkörpers (2) ausgebildet wird, **dadurch gekennzeichnet, dass** die elektrisch leitende Verbindung über die elektrisch leitfähige Struktur des elektronischen Moduls (3) ausgebildet wird.
